# EUROPÄISCHE PATENTSCHRIFT

(11) **EP 3 423 864 B1**
(45) Veröffentlichungstag und Bekanntmachung des Hinweises auf die Patenterteilung: **05.05.2021**
(21) Anmeldenummer: 17701879.3
(22) Anmeldetag: 30.01.2017
(51) Int. Cl.: G01S 15/931, B06B 1/02, G01S 7/524, G01S 15/87

(54) **FILTEREINRICHTUNG ZUM FILTERN EINER VERSORGUNGSSPANNUNG EINES ULTRASCHALLSENSORS EINES KRAFTFAHRZEUGS, ULTRASCHALLSENSORVORRICHTUNG SOWIE KRAFTFAHRZEUG**
FILTER APPARATUS FOR FILTERING OF A SUPPLY VOLTAGE OF AN ULTRASOUND SENSOR OF A VEHICLE, ULTRASOUND SENSOR APPARATUS AND VEHICLE
DISPOSITF DE FILTRE POUR FILTRAGE D'UNE TENSION D'ALIMENTATION D'UN CAPTEUR ULTRASONORE D'UN VÉHICULE, DISPOSITIF DE CAPTEUR ULTRASONORE ET VÉHICULE

(30) Priorität: 29.02.2016 DE 102016103514
(43) Veröffentlichungstag der Anmeldung: 09.01.2019
(73) Patentinhaber: Valeo Schalter und Sensoren GmbH, 74321 Bietigheim-Bissingen (DE)
(72) Erfinder: MOK, Erich, 74321 Bietigheim-Bissingen (DE)
(74) Vertreter: Enge, Sebastian
(86) Internationale Anmeldenummer: PCT/EP2017/051899
(87) Internationale Veröffentlichungsnummer: WO 2017/148633

(56) Entgegenhaltungen:
- EP-A2- 1 615 050
- DE-A1- 19 847 014
- JP-U- S57 151 943

## Beschreibung

Die vorliegende Erfindung betrifft eine Filtereinrichtung zum Filtern einer Versorgungsspannung eines Ultraschallsensors eines Kraftfahrzeugs, wobei die Filtereinrichtung eingangsseitig mit einer Spannungsquelle, welche die Versorgungsspannung bereitstellt, und ausgangsseitig mit dem Ultraschallsensor elektrisch verbindbar ist und wobei die Filtereinrichtung einen Tiefpass, welcher einen Widerstand und einen Kondensator aufweist, umfasst. Darüber hinaus betrifft die vorliegende Erfindung eine Ultraschallsensorvorrichtung mit einem Ultraschallsensor und einer solchen Filtereinrichtung. Schließlich betrifft die vorliegende Erfindung ein Kraftfahrzeug mit einer solchen Ultraschallsensorvorrichtung.

Das Interesse richtet sich vorliegend insbesondere auf Ultraschallsensoren für Kraftfahrzeuge. Derartige Ultraschallsensoren können beispielsweise an einem Stoßfänger des Kraftfahrzeugs angeordnet sein und dazu dienen, Objekte in der Umgebung des Kraftfahrzeugs zu erfassen. Um die Objekte erfassen zu können, wird mit dem Ultraschallsensor während einer Sendephase ein Ultraschallsignal ausgesendet. Dazu wird eine Membran des Ultraschallsensors mit einem entsprechenden Wandlerelement, beispielsweise einem piezoelektrischen Element, zu Schwingungen angeregt. Um das Wandlerelement während der Sendephase betreiben zu können, sind verhältnismäßig hohe elektrische Ströme erforderlich. In einer nachfolgenden Auswertephase wird das von dem Objekt reflektierte Ultraschallsignal wieder mit dem Ultraschallsensor empfangen. Während der Auswertephase wird das Wandlerelement nicht angeregt. Hierbei wird der Ultraschallsensor mit einem verhältnismäßig geringen Auswertestrom bzw. Betriebsstrom betrieben.

Die Ultraschallsensoren werden üblicherweise von einer Spannungsquelle des Kraftfahrzeugs mit elektrischer Energie versorgt. Um die von der Spannungsquelle bereitgestellte Versorgungsspannung filtern zu können, werden üblicherweise Filtereinrichtungen verwendet, die einen Tiefpass bzw. ein RC-Glied aufweisen. Die Filtereinrichtung umfasst also einen Widerstand und einen Kondensator, wobei sich in Abhängigkeit von der Dimensionierung des Widerstands und des Kondensators eine spezifische Zeitkonstante und hieraus eine Grenzfrequenz ergeben, ab der das Filter eine nennenswerte Dämpfung entwickelt. Aufgrund von Bauraumbeschränkungen ist es oft nicht möglich, Kondensatoren zu verwenden, die eine verhältnismäßig hohe Kapazität aufweisen. Wenn nun eine verhältnismäßig geringe Grenzfrequenz erreicht werden soll, müssen Widerstände verwendet werden, die einen hohen Widerstandswert aufweisen. Insbesondere während der Sendephase, bei welcher hohe elektrische Ströme bereitgestellt werden, führt dies zu einem erheblichen Spannungsabfall an dem Widerstand.

Hierzu beschreibt die EP 0 623 395 B1 eine Schaltungsanordnung zur Dämpfung eines Ultraschallwandlers. Die Schaltungsanordnung kann für einen Ultraschallwandler verwendet werden, der sowohl als Sender als auch als Empfänger ausgebildet ist. Die Schaltungsanordnung weist einen Generator auf, der ausgebildet ist, die Ansteuerspannung für den Ultraschallwandler derart zu steuern, dass die der Ansteuerspannung entsprechende Amplitude des abgestrahlten Ultraschallwandlersignals nach einer vorgegebenen Hüllkurve für die Abklingdauer abklingt. Ferner weist der Generator Mittel auf, durch das die vorgegebene Hüllkurve innerhalb einer Zeitdauer zunächst auf einen von Null verschiedenen Spannungswert abfällt und anschließend der Spannungswert der Hüllkurve für eine bestimmte Zeitdauer nahezu konstant ist. Dieses Mittel kann beispielweise ein als Tiefpass geschaltetes RC-Glied aufweisen.

Die DE 198 47 014 A1 offenbart eine Filtervorrichtung zum Ausfiltern von Versorgungsspannungsstörungen einer Spannungsquelle mit einem Tiefpass, wobei der Widerstand des Tiefpasses variabel ist Auch JP S 57-151943 U offenbart eine Filtervorrichtung zum Ausfiltern von Versorgungsspannungsstörungen einer Spannungsquelle mit einem Tiefpass. Der Widerstand wird gegen lastseitigen Kurzschluss durch eine parallele Diode geschützt.

Die EP 1 615 050 A2 offenbart eine Umfeldüberwachungseinrichtung mit mindestens einem Ultraschallsensor.

Es ist Aufgabe der vorliegenden Erfindung, eine Lösung aufzuzeigen, wie eine Filtereinrichtung für einen Ultraschallsensor der eingangs genannten Art auf einfache Weise effektiver betrieben werden kann.

Diese Aufgabe wird erfindungsgemäß durch eine Filtereinrichtung, durch eine Ultraschallsensorvorrichtung sowie durch ein Kraftfahrzeug mit den Merkmalen gemäß den jeweiligen unabhängigen Ansprüchen gelöst. Vorteilhafte Weiterbildungen der vorliegenden Erfindung sind Gegenstand der abhängigen Ansprüche, der Beschreibung und der Figuren.

Eine erfindungsgemäße Filtereinrichtung dient zum Filtern einer Versorgungsspannung eines Ultraschallsensors eines Kraftfahrzeugs. Die Filtereinrichtung kann eingangsseitig mit der Spannungsquelle, welche die Versorgungsspannung bereitstellt, und ausgangsseitig mit dem Ultraschallsensor elektrisch verbunden werden. Die Filtereinrichtung umfasst ferner einen Tiefpass, welcher einen Widerstand und einen Kondensator aufweist. Erfindungsgemäß ist es vorgesehen, dass die Filtereinrichtung eine Diode umfasst, welche parallel zu dem Widerstand geschaltet ist.

Die Filtereinrichtung kann für einen Ultraschallsensor eines Kraftfahrzeugs verwendet werden. Ein solcher Ultraschallsensor kann beispielsweise an einem Stoßfänger des Kraftfahrzeugs angeordnet sein. Dieser Ultraschallsensor kann eine Membran aufweisen, die beispielsweise aus Aluminium gefertigt ist und topfförmig ausgebildet sein kann. Ferner kann der Ultraschallsensor ein Wandlerelement, beispielsweise ein piezoelektrisches Element, aufweisen, mit dem die Membran bzw. ein Membranboden zu mechanischen Schwingungen angeregt werden kann. Um das Wandlerelement anzuregen, wird während einer Sendephase des Ultraschallsensors ein verhältnismäßig hoher Sendestrom benötigt. In einer nachfolgenden Auswertephase wird das Wandlerelement nicht mehr angeregt. Hierbei wird das von dem Objekt reflektierte Ultraschallsignal empfangen, das auf die Membran trifft und diese zu Schwingungen anregt. Diese Schwingungen der Membran können dann mit dem Wandlerelement erfasst werden. Während der Auswertephase wird der Ultraschallsensor mit einem verhältnismäßig geringen Auswertestrom versorgt. Dieser dient beispielsweise dazu, eine Recheneinrichtung, insbesondere einen Mikroprozessor, des Ultraschallsensors zu versorgen.

Die Versorgungsspannung wird mit einer Spannungsquelle des Kraftfahrzeugs bereitgestellt. Mit der Spannungsquelle kann auch ein elektrischer Strom bereitgestellt werden. Bei der Spannungsquelle kann es sich beispielsweise um eine Batterie oder um einen Akkumulator handeln. Die Spannungsquelle kann auch Teil eines Bordnetzes des Kraftfahrzeugs sein. Um die Versorgungsspannung, die mit der Spannungsquelle bereitgestellt wird, zu filtern, wird die Filtereinrichtung verwendet. Insbesondere sollen mit der Filtereinrichtung hochfrequente Signalanteile bzw. Störungen aus der Versorgungsspannung herausgefiltert werden. Zu diesem Zweck umfasst die Filtereinrichtung einen Tiefpass, welcher einen Widerstand und einen parallel zu dem Widerstand geschalteten Kondensator aufweist. Die Filtereinrichtung kann Eingangsklemmen aufweisen, die mit der Spannungsquelle des Kraftfahrzeugs elektrisch verbunden werden können. Dabei ist der Widerstand des Tiefpasses in Serie zu einer der Eingangsklemmen geschaltet und der Kondensator des Tiefpasses ist parallel zu den Eingangsklemmen geschaltet. Zudem kann die Filtereinrichtung Ausgangsklemmen aufweisen, die mit dem Ultraschallsensor elektrisch verbunden werden können.

Erfindungsgemäß ist es nun vorgesehen, dass die Filtereinrichtung zudem eine Diode umfasst, welche parallel zu dem Widerstand geschaltet ist. Durch das Parallelschalten der Diode mit dem Widerstand ergibt sich insbesondere bei den hohen Sendeströmen eine Begrenzung des Spannungsabfalls auf die Durchlassspannung bzw. die Diodenklemmspannung. Diese Durchlassspannung der Diode kann beispielsweise 0,5 V oder 0,7 V betragen. Somit kann die Filtereinrichtung insbesondere während der Sendephase des Ultraschallsensors effizienter betrieben werden.

Erfindungsgemäß sind der Widerstand und optional die Diode derart dimensioniert, dass die Diode leitet, falls ein vorbestimmet Sendestrom während einer Sendephase des Ultraschallsensors durch die Filtereinrichtung fließt. Während der Sendephase des Ultraschallsensors, bei der das Ultraschallsignal ausgesendet wird, wird der Sendestrom bereitgestellt, der beispielsweise 1 A betragen kann. Grundsätzlich kann es auch vorgesehen sein, dass ein gepulster Sendestrom während der Sendephase bereitgestellt wird. Dabei sind der Widerstand und optional die Diode derart dimensioniert, dass dieser Sendestrom einen Spannungsabfall an der Diode bewirkt, dass diese durchschaltet. Dies bedeutet, dass der Widerstandswert des Widerstands und optional die Durchlassspannung der Diode so gewählt, dass die Diode durchschaltet, falls der Sendestrom durch die Filtereinrichtung fließt. Somit wird der Spannungsabfall auf die Durchlassspannung der Diode begrenzt. Der Widerstand des Tiefpasses bzw. des RC-Glieds wird also quasi durch die Diode überbrückt. Nun hat der Tiefpass fast keine Filterwirkung mehr, dies ist aber oftmals in der Sendphase des Ultraschallsensors nicht erforderlich.

Ferner sind erfindungsgemäß der Widerstand und optional die Diode derart dimensioniert, dass die Diode sperrt, falls ein vorbestimmter Auswertestrom während einer Auswertephase des Ultraschallsensors durch die Filtereinrichtung fließt. Während der Auswertephase des Ultraschallsensors wird von zum Betrieb des Ultraschallsensors ein verhältnismäßig geringer Auswertestrom benötigt, der beispielsweise einige mA betragen kann. Dieser Auswertestrom dient beispielsweise dazu, eine Recheneinrichtung bzw. einen Mikroprozessor des Ultraschallsensors zu betreiben. Insbesondere während der Auswertephase ist es erforderlich, dass Störungen aus der Versorgungsspannung herausgefiltert werden. In diesem Fall sind der Widerstand und optional die Diode derart dimensioniert, dass die Diode bei dem Auswertestrom, der durch die Filtereinrichtung fließt, sperrt. Dies bewirkt, dass der Auswertestrom im Wesentlichen durch den Widerstand des Tiefpasses fließt. Hierbei ist die Diode, die parallel zu dem Widerstand geschaltet ist, also hochohmig. Dies bewirkt, dass die Zeitkonstante des Tiefpasses durch den Widerstand definiert wird. Somit kann die Versorgungsspannung während der Auswertephase zuverlässig gefiltert werden.

Insgesamt wird also eine Filtereinrichtung bereitgestellt, die sich dynamisch an den Betriebszustand - also die Sendephase oder die Auswertephase - des Ultraschallsensors anpasst. Dies wird durch die Diode erreicht, die parallel zu dem Widerstand geschaltet ist. Damit kann die Filtereinrichtung bauraumsparend und kostengünstig bereitgestellt werden.

In einer weiteren Ausführungsform umfasst die Filtereinrichtung eine weitere Diode, welche in Serie zu dem Widerstand geschaltet ist. Durch die weitere Diode, die elektrisch in Serie zu dem Widerstand geschaltet ist, kann ein Verpolschutz bereitgestellt werden. Somit kann eine Beschädigung des Ultraschallsensors verhindert werden, falls dieser fehlerhaft angeschlossen wird.

In einer weiteren Ausführungsform weist die Filtereinrichtung zumindest einen weiteren Kondensator auf, welcher parallel zu dem Kondensator des Tiefpasses geschaltet ist. Es kann beispielsweise vorgesehen sein, dass die Filtereinrichtung zwei weitere Kondensatoren aufweist, welche parallel zu dem Kondensator des Tiefpasses geschaltet sind. Diese weiteren Kondensatoren dienen insbesondere als Energiespeicher für eine Recheneinrichtung bzw. den Mikroprozessor des Ultraschallsensors. Somit kann erreicht werden, dass die Recheneinrichtung mit der erforderlichen Spannung versorgt wird.

Eine erfindungsgemäße Ultraschallsensorvorrichtung für ein Kraftfahrzeug umfasst einen Ultraschallsensor und eine erfindungsgemäße Filtereinrichtung. Dabei kann es vorgesehen sein, dass die Eingangsklemmen der Filtereinrichtung mit der Spannungsquelle des Kraftfahrzeugs, beispielsweise einer Batterie oder einem Bordnetz, elektrisch verbunden sind. Zudem können die Ausgangsklemmen der Filtereinrichtung mit dem Ultraschallsensor elektrisch verbunden sein.

Ein erfindungsgemäßes Kraftfahrzeug umfasst zumindest eine erfindungsgemäße Ultraschallsensorvorrichtung. Es kann auch vorgesehen sein, dass das Kraftfahrzeug eine Mehrzahl von Ultraschallsensorvorrichtungen aufweist. Dabei können die jeweiligen Ultraschallsensoren der Ultraschallsensorvorrichtungen verteilt an dem Kraftfahrzeug im Bereich der Stoßfänger angeordnet sein. Das Kraftfahrzeug ist insbesondere als Personenkraftwagen ausgebildet.

Die mit Bezug auf die erfindungsgemäße Filtereinrichtung vorgestellten bevorzugten Ausführungsformen und deren Vorteile gelten entsprechend für die erfindungsgemäße Ultraschallsensorvorrichtung sowie für das erfindungsgemäße Kraftfahrzeug.

Weitere Merkmale der Erfindung ergeben sich aus den Ansprüchen, den Figuren und der Figurenbeschreibung.

Die Erfindung wird nun anhand von bevorzugten Ausführungsbeispielen sowie unter Bezugnahme auf die beigefügten Zeichnungen näher erläutert.

### Dabei zeigen:

- Fig. 1: ein Kraftfahrzeug gemäß einer Ausführungsform der vorliegenden Erfindung, welches eine Mehrzahl von Ultraschallsensorvorrichtungen aufweist;
- Fig. 2: eine schematische Darstellung einer Ultraschallsensorvorrichtung, die mit einer Spannungsquelle des Kraftfahrzeugs verbunden ist;
- Fig. 3: eine Schaltung einer Filtereinrichtung der Ultraschallsensorvorrichtung gemäß dem Stand der Technik; und
- Fig. 4: eine Schaltung einer Filtereinrichtung gemäß einer Ausführungsform der vorliegenden Erfindung.

In den Figuren werden gleiche und funktionsgleiche Elemente mit den gleichen Bezugszeichen versehen.

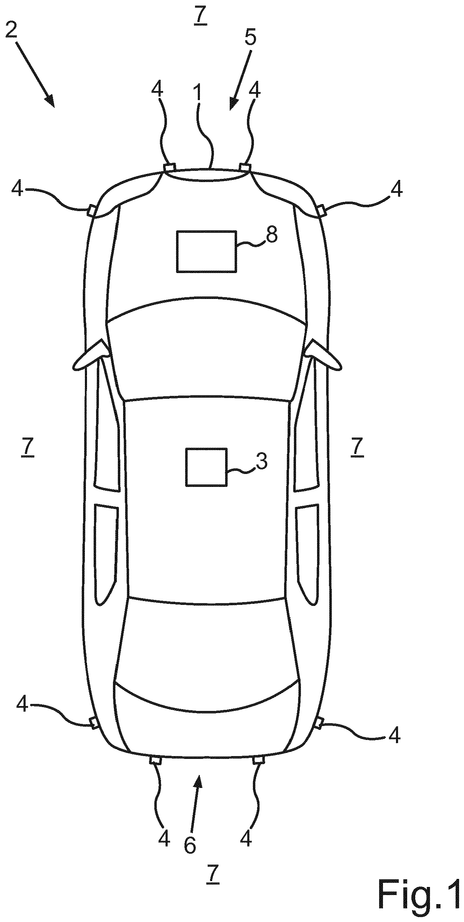

Fig. 1 zeigt ein Kraftfahrzeug 1 gemäß einer Ausführungsform der vorliegenden Erfindung in einer Draufsicht. Das Kraftfahrzeug 1 ist vorliegend als Personenkraftwagen ausgebildet. Das Kraftfahrzeug 1 umfasst ein Fahrerassistenzsystem 2, welches wiederum eine Steuereinrichtung 3 umfasst. Darüber hinaus umfasst das Fahrerassistenzsystem 2 zumindest eine Ultraschallsensorvorrichtung 4. Vorliegend umfasst das Fahrerassistenzsystem 2 acht Ultraschallsensorvorrichtungen 4, wobei vier Ultraschallsensorvorrichtungen 4 in einem Frontbereich 5 des Kraftfahrzeugs 1 und vier Ultraschallsensorvorrichtungen 4 in einem Heckbereich 6 des Kraftfahrzeugs 1 angeordnet sind. Wie nachfolgend näher erläutert, umfassen die jeweiligen Ultraschallsensorvorrichtungen 4 jeweils einen Ultraschallsensor 10, mit dem Objekte in einem Umgebungsbereich 7 des Kraftfahrzeugs erfasst werden können. Dabei können die Ultraschallsensoren 10 an den Stoßfängern des Kraftfahrzeugs 1 angeordnet sein. Die jeweiligen Ultraschallsensorvorrichtungen 4 können mittels der Steuereinrichtung 3 angesteuert werden.

Das Kraftfahrzeug 1 umfasst ferner eine Spannungsquelle 8, die beispielsweise durch einen elektrischen Energiespeicher des Kraftfahrzeugs 1 bereitgestellt wird. Ein solcher elektrischer Energiespeicher des Kraftfahrzeugs 1 kann beispielsweise eine Batterie oder ein Bordnetz des Kraftfahrzeugs 1 sein. Die jeweiligen Ultraschallsensorvorrichtungen 4 sind elektrisch mit der Spannungsquelle 8 verbunden. Die Ultraschallsensorvorrichtungen 4 bzw. die Ultraschallsensoren 10 werden im Betrieb von der Spannungsquelle 8 mit elektrischer Energie versorgt.

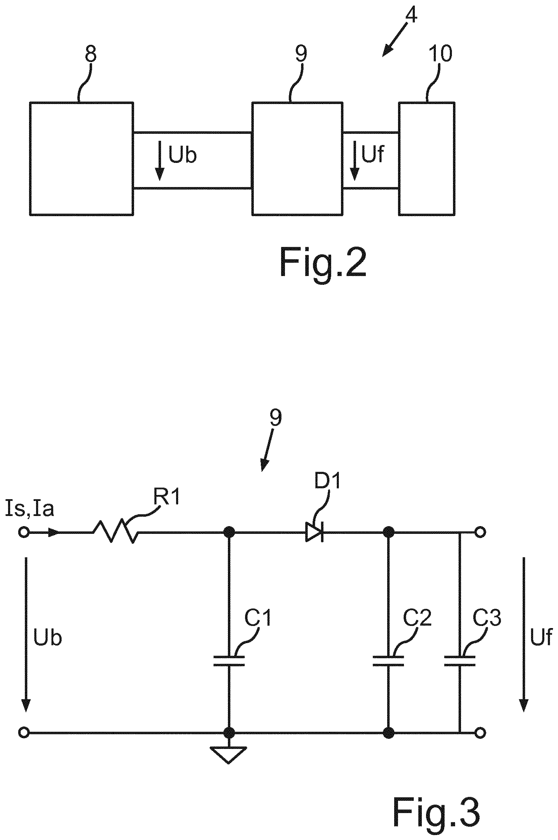

Fig. 2 zeigt eine schematische Darstellung einer Ultraschallsensorvorrichtung 4, die elektrisch mit der Spannungsquelle 8 verbunden ist. Von der Spannungsquelle 8 wird eine Versorgungsspannung Ub bereitgestellt. Die Ultraschallsensorvorrichtung 4 umfasst eine Filtereinrichtung 9, welche dazu dient, diese Versorgungsspannung Ub zu filtern. Die Filtereinrichtung 9 ist eingangsseitig mit der Spannungsquelle 8 verbunden. Ausgangsseitig ist die Filtereinrichtung 9 mit dem Ultraschallsensor 10 verbunden. Am Ausgang der Filtereinrichtung 9 liegt die gefilterte Versorgungsspannung Uf an. Mit dieser gefilterten Versorgungsspannung Uf wird der Ultraschallsensor 10 versorgt.

Der Ultraschallsensor 10 dient einerseits dazu, ein Ultraschallsignal während einer Sendephase auszusenden. In einer nachfolgenden Auswertephase wird das von dem Objekt reflektierte Ultraschallsignal mit Hilfe des Ultraschallsensors 10 wieder empfangen. Der Ultraschallsensor 10 umfasst eine Membran, die mit Hilfe eines entsprechenden Wandlerelements zu mechanischen Schwingungen angeregt wird. Um das Wandlerelement zu betreiben, wird während der Sendephase ein Sendestrom Is bereitgestellt, der beispielsweise 1 A betragen kann. In der nachfolgenden Auswertephase wird das Wandlerelement nicht betrieben. Hier wird mit der Spannungsquelle 8 ein Auswertestrom Ia bereitgestellt, mit dem der Ultraschallsensor 10 und insbesondere eine Recheneinheit bzw. ein Mikroprozessor des Ultraschallsensors 10 betrieben wird. Während der Auswertephase wird mit Hilfe des Wandlerelements das reflektierte Ultraschallsignal, das auf die Membran trifft und diese zu Schwingungen anregt, erfasst. Insbesondere während der Auswertephase des Ultraschallsensors 10 ist es erforderlich, dass Störungen aus der Versorgungsspannung Ub herausgefiltert werden, um die reflektierten Ultraschallsignale zuverlässig erfassen zu können.

Fig. 3 zeigt eine Schaltung einer Filtereinrichtung 9 gemäß dem Stand der Technik. Die Schaltung weist die Eingangsklemmen auf, an denen die Versorgungsspannung Ub der Spannungsquelle 8 anliegt. Ferner umfasst die Filtereinrichtung 9 einen Tiefpass bzw. ein RC-Glied. Dieser Tiefpass umfasst einen Widerstand R1 und einen Kondensator C1. Dabei ist der Kondensator C1 parallel zu den Eingangsklemmen und parallel zu dem Widerstand R1 geschaltet. Abhängig von dem Widerstandswert des Widerstands R1 und der Kapazität des Kondensators C1 ergibt sich eine spezifische Zeitkonstante τ = R1*C1. Die Grenzfrequenz fg des Tiefpasses ergibt sich zu: fg = ½*π*τ.

Die Kapazität des Kondensators C1 kann aufgrund von Bauraumbeschränkungen nicht beliebig hoch gewählt werden. Beispielsweise kann die Kapazität des Kondensators C1 100 nF betragen. Wenn der Widerstand R1 einen Widerstandswert von 100 Ohm aufweist, ergeben sich eine Zeitkonstante von 6,8 ms und eine Grenzfrequenz von 24 Hz. Wenn während der Sendephase ein Sendestrom Is durch den Widerstand fließt, der 1 A beträgt, ergibt sich am Widerstand R1 ein Spannungsabfall von 100 V.

Um einen derartig erheblichen Spannungsabfall an dem Widerstand R1 zu vermeiden, könnte der Widerstandswert des Widerstands R1 sehr klein gewählt werden. Wenn beispielsweise der Widerstandswert des Widerstands R1 0,5 Ohm betragen würde, ergibt sich eine Zeitkonstante von 10 µs und eine Grenzfrequenz von 16 kHz. Hierbei würde sich bei einem Sendestrom Is von 1 A ein Spannungsabfall von 0,5 V ergeben. In diesem Fall ergibt sich ein geringer Spannungsabfall an dem Widerstand R1. Dies hat aber wiederum zur Folge, dass die Grenzfrequenz fg des Tiefpasses bei gleichbleibender Kapazität des Kondensators C1 sehr stark ansteigt, so dass die Filterwirkung erheblich abnimmt. Die Filtereinrichtung 9 umfasst zudem eine Diode D1, die in Serie zu dem Widerstand R1 geschaltet ist. Diese Diode D1 dient als Verpolschutz. Darüber hinaus umfasst die Filtereinrichtung die weiteren Kondensatoren C2 und C3. Die Kapazitäten der Kondensatoren C2 und C3 können jeweils 10 µF betragen. Diese Kondensatoren C2 und C3 dienen als Energiespeicher für die Recheneinrichtung bzw. den Mikroprozessor des Ultraschallsensors 10.

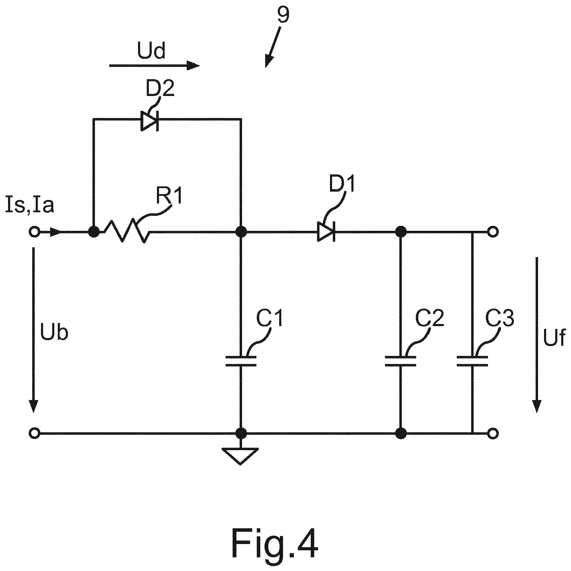

Fig. 4 zeigt eine Schaltung einer Filtereinrichtung 9 gemäß einer Ausführungsform der Erfindung. Die Filtereinrichtung 9 umfasst im Vergleich zu der Schaltung gemäß Fig. 3 zusätzlich eine Diode D2, die parallel zu dem Widerstand R1 geschaltet ist. Durch das Parallelschalten der Diode D2 zu dem Widerstand R1 ergibt sich bei dem hohen Sendestrom Is eine Begrenzung des Spannungsabfalls auf die Durchlassspannung Ud bzw. die Diodenklemmspannung. Die Durchlassspannung Ud der Diode D2 kann beispielsweise 0,5 V betragen. Wenn während der Sendephase der Sendestrom Is bereitgestellt wird, hat der Tiefpass fast zwar keine Filterwirkung mehr, dies ist aber während der Sendephase des Ultraschallsensors 10 nicht erforderlich. Während der Auswertephase, bei welcher der Tiefpass von dem Auswertestrom Ia durchflossen wird, ist die Diode D2 hochohmig, so dass jetzt die Filterzeitkonstante über den Widerstand R1 definiert wird. Mit diesem wesentlich höheren Wert ergibt sich somit eine wesentlich bessere Filterwirkung.

Hierbei ist es erforderlich, dass der Widerstand R1 so dimensioniert wird, dass die Diode D2 bei dem Auswertestrom Ia bzw. bei dem Betriebsstrom hochohmig ist. Es muss also gelten: R1*Ia < Ud. Wenn der Widerstand R1 einen Widerstand von 100 Ohm aufweist, ergibt sich bei einer Kapazität des Kondensators C1 von 100 nF eine Grenzfrequenz von 24 Hz. Wenn der Sendestrom Is bereitgestellt wird, der 1 A beträgt, ergibt sich an der Diode D2 ein Spannungsabfall in Höhe der Durchlassspannung Ud, die beispielsweise 0,5 V betragen kann. Für die Auswertephase muss gelten, dass der Auswertestrom Ia < Ud/R1 ist. Selbst wenn mit einer Durchlassspannung Ud von 0,4 V gerechnet wird, ergibt sich ein zulässiger Strom von 4 mA für den Auswertestrom Ia bzw. den Betriebsstrom. Bei einem derartigen Strom kann die volle Filterwirkung des Tiefpasses bzw. des RC-Glieds realisiert werden. Gleichzeitig kann während der Sendephase der Sendestrom Is bereitgestellt werden, ohne einen übermäßigen Spannungsabfall zu erzeugen. Dabei kann es auch vorgesehen sein, dass während der Sendephase ein gepulster Sendestrom Is bereitgestellt wird. Mit dieser Schaltung bzw. dieser Filtereinrichtung sind also hohe Pulsströme für die Sendephase möglich und dennoch kann in der anschließenden Auswertephase mit dem geringen Auswertestrom Ia die vorteilhafte Filterwirkung des Tiefpasses erreicht werden. Somit kann durch die Filtereinrichtung 9 insgesamt ein dynamisches Versorgungsspannungsfilter bereitgestellt werden.

## Patentansprüche

1. Filtereinrichtung (9) zum Filtern einer Versorgungsspannung (Ub) eines Ultraschallsensors (10) eines Kraftfahrzeugs (1), wobei die Filtereinrichtung (9) eingangsseitig mit einer Spannungsquelle (8), welche die Versorgungsspannung (Ub) bereitstellt, und ausgangsseitig mit dem Ultraschallsensor (10) elektrisch verbindbar ist und wobei die Filtereinrichtung (9) einen Tiefpass mit einem Widerstand (R1) und einem Kondensator (C1) umfasst, wobei die Filtereinrichtung (9) eine Diode (D2) umfasst, welche parallel zu dem Widerstand (R1) geschaltet ist,
wobei der Widerstand (R1) und optional die Diode (D2) derart dimensioniert sind, dass die Diode (D2) leitet, falls ein vorbestimmter Sendestrom (Is) während einer Sendephase des Ultraschallsensors (10) durch die Filtereinrichtung (9) fließt und die Diode (D2) sperrt, falls ein vorbestimmter Auswertestrom (la) während einer Auswertephase des Ultraschallsensors (10) durch die Filtereinrichtung (9) fließt.

2. Filtereinrichtung (9) nach Anspruch 1,
**dadurch gekennzeichnet, dass**
die der Widerstand (R1) und optional die Diode (D2) derart dimensioniert sind, dass ein
Widerstandswert des Widerstands (R1) kleiner als ein Quotient aus einer Durchlassspannung (Ud) der Diode (D2) und dem Auswertestrom (la) ist.

3. Filtereinrichtung (9) nach einem der vorhergehenden Ansprüche,
**dadurch gekennzeichnet, dass**
die Filtereinrichtung (9) eine weitere Diode (D1) umfasst, welche in Serie zu dem Widerstand (R1) des Tiefpasses geschaltet ist.

4. Filtereinrichtung (9) nach einem der vorhergehenden Ansprüche,
**dadurch gekennzeichnet, dass**
die Filtereinrichtung (9) zumindest einen weiteren Kondensator (C2, C3) aufweist, welcher parallel zu dem Kondensator (C1) des Tiefpasses geschaltet ist.

5. Ultraschallsensorvorrichtung (4) für ein Kraftfahrzeug (1) mit einem Ultraschallsensor (10) und einer Filtereinrichtung (9) nach einem der vorhergehenden Ansprüche.

6. Kraftfahrzeug (1) mit zumindest einer Ultraschallsensorvorrichtung (4) nach Anspruch 5.

## Claims

1. Filter device (9) for filtering a supply voltage (Ub) of an ultrasonic sensor (10) of a motor vehicle (1), wherein the filter device (9) can be electrically connected, on the input side, to a voltage source (8), which provides the supply voltage (Ub), and can be electrically connected, on the output side, to the ultrasonic sensor (10), and wherein the filter device (9) comprises a low-pass filter having a resistor (R1) and a capacitor (C1), wherein the filter device (9) comprises a diode (D2) which is connected in parallel with the resistor (R1), wherein the resistor (R1) and optionally the diode (D2) are dimensioned in such a manner that the diode (D2) is on if a predetermined transmission current (Is) flows through the filter device (9) during a transmission phase of the ultrasonic sensor (10) and the diode (D2) is off if a predetermined evaluation current (Ia) flows through the filter device (9) during an evaluation phase of the ultrasonic sensor (10).

2. Filter device (9) according to Claim 1,
**characterized in that**
the resistor (R1) and optionally the diode (D2) are dimensioned in such a manner that a resistance value of the resistor (R1) is less than a quotient of a forward voltage (Ud) of the diode (D2) and the evaluation current (Ia) .

3. Filter device (9) according to one of the preceding claims,
**characterized in that**
the filter device (9) comprises a further diode (D1) which is connected in series with the resistor (R1) of the low-pass filter.

4. Filter device (9) according to one of the preceding claims,
**characterized in that**
the filter device (9) has at least one further capacitor (C2, C3) which is connected in parallel with the capacitor (C1) of the low-pass filter.

5. Ultrasonic sensor apparatus (4) for a motor vehicle (1), having an ultrasonic sensor (10) and a filter device (9) according to one of the preceding claims.

6. Motor vehicle (1) having at least one ultrasonic sensor apparatus (4) according to Claim 5.

## Revendications

1. Dispositif de filtrage (9) destiné à filtrer une tension d'alimentation (Ub) d'un capteur à ultrasons (10) d'un véhicule automobile (1), le dispositif de filtrage (9) pouvant être relié électriquement, du côté entrée, à une source de tension (8), qui fournit la tension d'alimentation (Ub), et, du côté sortie, au capteur à ultrasons (10) et le dispositif de filtrage (9) comprenant un filtre passe-bas muni d'une résistance (R1) et d'un condensateur (C1), le dispositif de filtrage (9) comprenant une diode (D2) qui est montée en parallèle avec la résistance (R1), la résistance (R1) et éventuellement la diode (D2) étant dimensionnées de telle sorte que la diode (D2) soit conductrice si un courant d'émission prédéterminé (Is) circule à travers le dispositif de filtrage (9) pendant une phase d'émission du capteur à ultrasons (10) et que la diode (D2) soit bloquée si un courant d'évaluation prédéterminé (Ia) circule à travers le dispositif de filtrage (9) pendant une phase d'évaluation du capteur à ultrasons (10).

2. Dispositif de filtrage (9) selon la revendication 1,
**caractérisé en ce que**
la résistance (R1) et éventuellement la diode (D2) sont dimensionnées de telle sorte que la valeur de la résistance (R1) soit inférieure au quotient de la tension directe (Ud) de la diode (D2) et du courant d'évaluation (Ia).

3. Dispositif de filtrage (9) selon l'une des revendications précédentes,
**caractérisé en ce que**
le dispositif de filtrage (9) comprend une autre diode (D1) qui est montée en série avec la résistance (R1) du filtre passe-bas.

4. Dispositif de filtrage (9) selon l'une des revendications précédentes,
**caractérisé en ce que**
le dispositif de filtrage (9) comporte au moins un autre condensateur (C2, C3) qui est monté en parallèle avec le condensateur (C1) du filtre passe-bas.

5. Dispositif de capteur à ultrasons (4) destiné à un véhicule automobile (1) et comprenant un capteur à ultrasons (10) et un dispositif de filtrage (9) selon l'une des revendications précédentes.

6. Véhicule automobile (1) comprenant au moins un dispositif de capteur à ultrasons (4) selon la revendication 5.
